(19) Europäisches Patentamt
European Patent Office
Office européen des brevets

(11) **EP 3 439 047 A1**

(12) **EUROPEAN PATENT APPLICATION**
published in accordance with Art. 153(4) EPC

(43) Date of publication:
06.02.2019 Bulletin 2019/06

(51) Int Cl.:
*H01L 31/0216* (2014.01)    *H01L 31/048* (2014.01)

(21) Application number: 17773986.9

(22) Date of filing: 27.02.2017

(86) International application number:
PCT/JP2017/007488

(87) International publication number:
WO 2017/169441 (05.10.2017 Gazette 2017/40)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 28.03.2016   JP 2016064373
01.08.2016   JP 2016151024

(71) Applicant: Sharp Kabushiki Kaisha
Sakai City, Osaka 590-8522 (JP)

(72) Inventors:
• HOSHINA, Yutaka
  Sakai City
  Osaka 590-8522 (JP)
• SAWADA, Kohei
  Sakai City
  Osaka 590-8522 (JP)
• MATSUBARA, Hiroshi
  Sakai City
  Osaka 590-8522 (JP)

(74) Representative: Müller Hoffmann & Partner
Patentanwälte mbB
St.-Martin-Strasse 58
81541 München (DE)

(54) **BACK CONTACT SOLAR CELL, SOLAR CELL MODULE AND SOLAR PHOTOVOLTAIC POWER GENERATION SYSTEM**

(57)    A back contact solar battery cell includes a first-conductivity-type impurity-containing region (2) and a second-conductivity-type impurity-containing region (3) formed in a first surface (1b) of a semiconductor substrate (1) of a first or second conductivity type; and a silicon nitride film (7) on a second surface (1a) of the semiconductor substrate (1). The silicon nitride film (7) has a nitrogen mass ratio of 0.38 or less.

FIG.1

**Description**

Technical Field

The present invention relates to a back contact solar battery cell, a solar battery module, and a solar power generation system. The present application claims priority to Japanese Patent Application No. 2016-064373 filed March 28, 2016, and Japanese Patent Application No. 2016-151024 filed August 1, 2016. All the contents in these Japanese patent applications are incorporated herein by reference.

Background Art

Development of clean energy has been long anticipated in view of issues such as depletion of energy resources and global environmental issues such as the rise in $CO_2$ level in air; solar power generation using solar batteries has been developed and put to practical application as a new energy source, and is still evolving.

In particular, recent years have seen increasing use of solar battery modules, which are constituted by connecting multiple solar battery cells in series and/or parallel, in general household, and have also seen construction of large-scale power generation facilities called mega solar parks that use large quantities of solar battery modules.

The solar battery modules described above are used outdoors for a long period of time and are required to have long-term reliability in all types of outdoor environments such as a high-temperature, high-humidity environment. It has been believed that since solar battery cells that constitute solar battery modules are mainly manufactured by using crystalline silicon, a relatively long service life can be anticipated, and thus the long-term reliability of the solar battery modules has been improved by mainly focusing on the parts of the solar battery modules other than the solar battery cells.

However, recently, a phenomenon in which the output of solar battery modules significantly drops despite a relatively short period of use, namely, potential induced degradation (PID), has emerged, and identifying the cause of the phenomenon and promptly establishing the countermeasures are strongly urged.

For example, PTL 1 describes that the PID can be addressed by using a solar battery sealing material that contains a sealing resin, a silane coupling agent, and a crosslinking agent and has a water contact angle θ of 80° to 86° at a surface when the sealing resin is crosslinked with the crosslinking agent.

Moreover, PTL 2 describes that when the minimum thickness of a sealing material from the outer surface of a solar battery element group is assumed to be T [m] and the breakdown voltage of the sealing material saturated with water is assumed to be Vb [V/m], the PID can be addressed by setting the product of the minimum thickness T and the breakdown voltage Vb to be higher than or equal to the maximum system voltage.

Citation List

Patent Literature

PTL 1: Japanese Unexamined Patent Application Publication No. 2015-95593
PTL 2: Japanese Unexamined Patent Application Publication No. 2014-11270

Summary of Invention

Technical Problem

However, it has recently been found that when PID is addressed by using a sealing material, variations in physical properties, thickness, etc., of the sealing material or the unforeseen load from the outside environment may cause PID, and, thus, it is desirable that the PID be addressed by the solar battery cells themselves.

Moreover, in recent years, from the viewpoint of producing high-efficiency solar battery modules, back contact solar battery cells with electrodes on the back surfaces have also been developed.

Solution to Problem

An embodiment disclosed herein is a back contact solar battery cell that includes a semiconductor substrate of a first or second conductivity type; a first-conductivity-type impurity-containing region and a second-conductivity-type impurity-containing region formed in a first surface of the semiconductor substrate; and a silicon nitride film on a second surface of the semiconductor substrate, the second surface being on the opposite side of the first surface, in which the silicon nitride film has a nitrogen mass ratio of 0.38 or less.

An embodiment disclosed herein is a solar battery module, in which at least a glass substrate, a sealing material, and the back contact solar battery cell described above are disposed in that order from a light-receiving-surface side, the back contact solar battery cell is arranged so that the second surface is disposed on the light-receiving-surface side, and the sealing material has a resistivity of $1 \times 10^{15}$ Ωcm or less at 60°C.

An embodiment disclosed herein is a solar power generation system that includes the solar battery module described above.

Advantageous Effects of Invention

According to the embodiments disclosed herein, the PID resistance can be enhanced by the back contact solar battery cell itself.

Brief Description of Drawings

Fig. 1 is a schematic cross-sectional view of a back contact solar battery cell according to a first embodiment.

Fig. 2 is a schematic cross-sectional view illustrating one example of a method for producing a back contact solar battery cell of the first embodiment.

Fig. 3 is a schematic cross-sectional view illustrating one example of a method for producing a back contact solar battery cell of the first embodiment.

Fig. 4 is a schematic cross-sectional view illustrating one example of a method for producing a back contact solar battery cell of the first embodiment.

Fig. 5 is a schematic cross-sectional view illustrating one example of a method for producing a back contact solar battery cell of the first embodiment.

Fig. 6 is a schematic cross-sectional view illustrating one example of a method for producing a back contact solar battery cell of the first embodiment.

Fig. 7 is a schematic diagram of a CVD device used in forming a silicon nitride film on a light-receiving surface of the back contact solar battery cell of the first embodiment.

Fig. 8 is a schematic plan view of a surface of one example of a wiring sheet used in a solar battery module of the first embodiment.

Fig. 9 is a schematic plan view illustrating a state in which the back contact solar battery cells are installed on the wiring sheet illustrated in Fig. 8.

Fig. 10 is a schematic cross-sectional view of a solar battery module of the first embodiment.

Fig. 11 is a graph showing the relationship between the volume resistivity [Ωcm] of the sealing material on the light-receiving-surface side at 60°C and the voltage [V] applied to the silicon nitride film indicated in Table 1.

Fig. 12 is a graph showing the relationship between the volume resistivity [Ωcm] of the sealing material on the light-receiving-surface side at 60°C and the voltage [V] applied to the silicon nitride film indicated in Table 2.

Fig. 13 is a graph showing the relationship between the volume resistivity [Ωcm] of the sealing material on the light-receiving-surface side at 60°C and the voltage [V] applied to the silicon nitride film indicated in Table 3.

Fig. 14 is a schematic cross-sectional view of a back contact solar battery cell according to a second embodiment.

Fig. 15 is a schematic cross-sectional view of a back contact solar battery cell according to a third embodiment.

Fig. 16 is a graph showing the relationship between the ratio of the flow rate of the $SiH_4$ gas to the sum of the flow rate of the $SiH_4$ gas and the flow rate of the $NH_3$ gas during formation of the silicon nitride film in Example 1, and the nitrogen mass ratio in the silicon nitride film.

Fig. 17 is a diagram illustrating a simulated positive electrode grounding test of Example 1.

Fig. 18 is a graph showing the relationship between the nitrogen mass ratio in the silicon nitride film of a back contact solar battery cell of Example 1 and the rate of decrease in cell output before and after the simulated positive electrode grounding test.

Fig. 19 is a diagram illustrating a simulated negative electrode grounding test of Example 2.

Fig. 20 is a graph showing the relationship between the nitrogen mass ratio in the silicon nitride film of a back contact solar battery cell of Example 2 and the rate of decrease in cell output before and after the simulated negative electrode grounding test.

Fig. 21 is a graph showing the relationship between the nitrogen mass ratio in the silicon nitride film of a back contact solar battery cell of Example 3 and the rate of decrease in cell output before and after the simulated negative electrode grounding test. Description of Embodiments

The embodiments disclosed herein will now be described. In the drawings referred to in the description of the embodiments, the same reference signs denote the same or corresponding parts.

[First embodiment]

<Back contact solar battery cell>

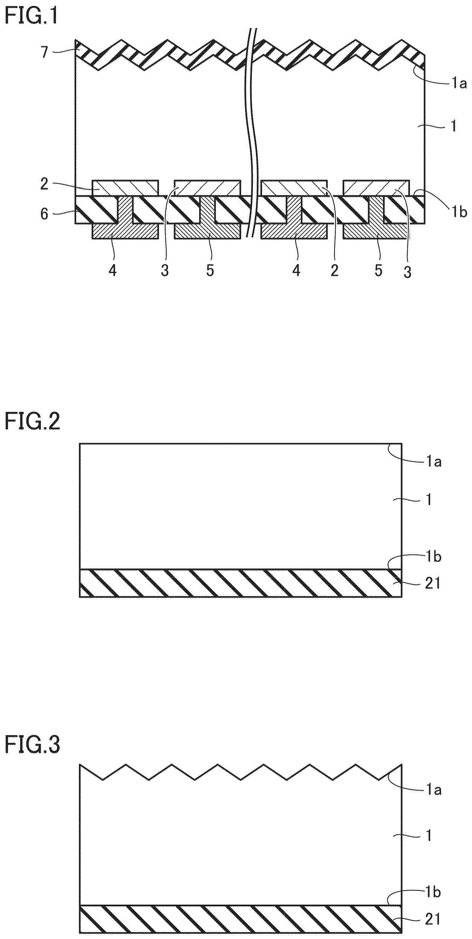

Fig. 1 is a schematic cross-sectional view of a back contact solar battery cell according to a first embodiment. The back contact solar battery cell of the first embodiment includes a semiconductor substrate 1 of a first or second conductivity type, a silicon nitride film 7 on a light-receiving surface 1a of the semiconductor substrate 1, a dielectric film 6 on a back surface 1b of the semiconductor substrate 1, strip-shaped n-type impurity-containing regions 2 and strip-shaped p-type impurity-containing regions 3 alternately disposed on the back surface 1b of the semiconductor substrate 1 while being spaced from one another, n-electrodes 4 on the n-type impurity-containing regions 2, and p-electrodes 5 on the p-type impurity-containing regions 3.

Since the nitrogen mass ratio ((mass of nitrogen in silicon nitride film 7)/(sum of mass of silicon and mass of nitrogen in silicon nitride film 7)) in the silicon nitride film 7 of the back contact solar battery cell of the first embodiment is 0.38 or less, the back contact solar battery cell of the first embodiment itself can have the PID resistance (the properties to suppress occurrence of the PID). Here, from the viewpoints of reducing the light absorption in the silicon nitride film 7 and improving the output current of the back contact solar battery cell, the nitrogen mass ratio in the silicon nitride film 7 is preferably 0.28 or more and more preferably 0.30 or more. Furthermore, from the viewpoint of further improving the PID resistance of the back contact solar battery cell itself, the nitrogen mass ratio in the silicon nitride film 7 is preferably 0.36 or less. Note that the nitrogen mass ratio in the silicon nitride film 7 can be measured by performing elemental composition analysis on the silicon nitride film 7 by secondary ion mass spectrometry or glow discharge optical emission spectrometry. Alternatively, the nitrogen mass ratio in the silicon nitride film 7 may be measured by performing elemental composition analysis through Auger electron spectroscopy or Rutherford backscattering spectrometry.

The silicon nitride film 7 may contain, for example, 10 to 30 atom% of hydrogen as the atoms other than nitrogen and silicon; alternatively, impurity atoms, such as oxygen and carbon, may be contained instead of or in addition to hydrogen atoms.

One example of a method for producing a back contact solar battery cell of the first embodiment will now be described with reference to schematic cross-sectional views in Figs. 2 to 6.

First, as illustrated in Fig. 2, a texture mask 21 is formed on the back surface 1b, which is a first surface of the semiconductor substrate 1, and, then, as illustrated in Fig. 3, a textured shape is formed on the light-receiving surface 1a, which is a second surface of the semiconductor substrate 1.

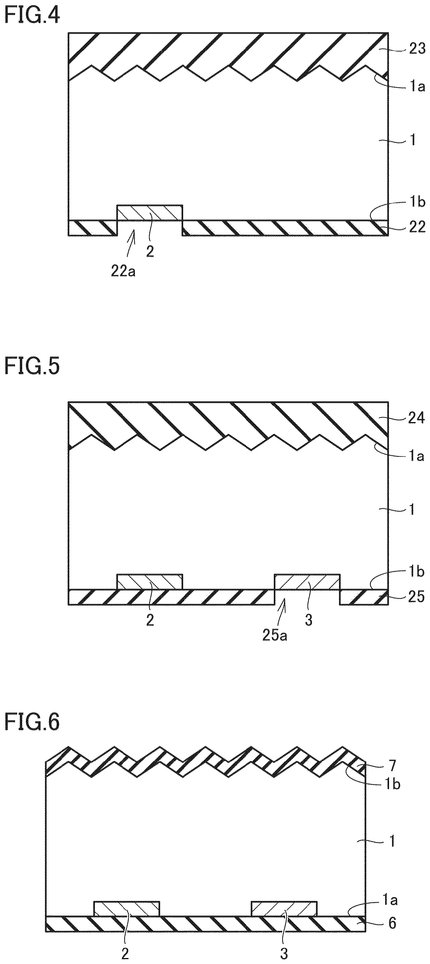

Next, after the texture mask 21 on the back surface 1b of the semiconductor substrate 1 is removed, a diffusing mask 23 is formed on the light-receiving surface 1a of the semiconductor substrate 1, and a diffusing mask 22 having an opening 22a is formed on the back surface 1b, as illustrated in Fig. 4. Next, an n-type impurity is diffused into the back surface 1b of the semiconductor substrate 1 through the opening 22a in the diffusing mask 22 so that an n-type impurity-containing region 2, which is a first-conductivity-type impurity-containing region, is formed in a part of the back surface 1b of the semiconductor substrate 1.

Next, after the diffusing mask 23 on the light-receiving surface 1a of the semiconductor substrate 1 and the diffusing mask 22 on the back surface 1b are removed, a diffusing mask 24 is formed on the light-receiving surface 1a of the semiconductor substrate 1 and a diffusing mask 25 having an opening 25a is formed on the back surface 1b, as illustrated in Fig. 5. Next, a p-type impurity is diffused into the back surface 1b of the semiconductor substrate 1 through the opening 25a in the diffusing mask 25 so that a p-type impurity-containing region 3, which is a second-conductivity-type impurity-containing region, is formed in a part of the back surface 1b of the semiconductor substrate 1.

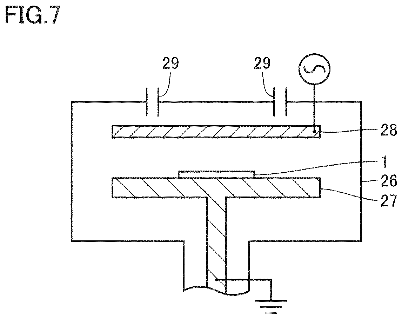

Next, as illustrated in Fig. 6, a silicon nitride film 7 is formed on the light-receiving surface 1a of the semiconductor substrate 1 and a dielectric film 6 is formed on the back surface 1b of the semiconductor substrate 1. In particular, the silicon nitride film 7 on the light-receiving surface 1a of the semiconductor substrate 1 can be formed as follows by using a chemical vapor deposition (CVD) device illustrated in Fig. 7, for example.

First, the semiconductor substrate 1, on which the n-type impurity-containing regions 2 and the p-type impurity-containing regions 3 are already formed, is placed on a lower electrode 27 inside a deposition chamber 26 of the CVD device illustrated in Fig. 7. Next, $SiH_4$ (silane) gas and $NH_3$ (ammonia) gas are introduced into the inside of the deposition chamber 26 through a gas inlet port 29. Here, the flow rate of the $SiH_4$ gas and the flow rate of the $NH_3$ gas are adjusted so that the nitrogen mass ratio in the silicon nitride film 7 is 0.38 or less, preferably 0.28 or more and 0.38 or less, and more preferably 0.30 or more and 0.36 or less.

In this embodiment, the case in which the $SiH_4$ gas and the $NH_3$ gas are introduced into the inside of the deposition chamber 26 is described; alternatively, $N_2$ (nitrogen) gas may be introduced in addition to the $SiH_4$ gas and the $NH_3$ gas.

The thickness of the silicon nitride film 7 is preferably 30 nm or more and 110 nm or less and more preferably 50 nm or more and 100 nm or less. The back contact solar battery cell of the first embodiment can constitute a solar battery module when, as described below, at least a glass substrate, a sealing material, and the back contact solar battery cell of the first embodiment are disposed in that order from the light-receiving-surface side. It has been found that when the thickness of the silicon nitride film 7 is 30 nm or more and particularly 50 nm or more, sufficient PID resistance can be obtained.

Typically, a silicon nitride film is a mixture of microcrystal phases and amorphous phases, and it is known that the proportion of the amorphous phases increases and the proportion of the microcrystal phases decreases as the silicon mass ratio in the film increases. The sodium (Na) ions that have entered the silicon nitride film are thought to propagate through crystal/amorphous interphases. In the silicon nitride film 7 in which the nitrogen mass ratio is 0.38 or less, preferably 0.28 or more and 0.38 or less, and more preferably 0.30 or more and 0.36 or less, there are relatively fewer crystal/amorphous interphases, and migration of Na ions is suppressed. Thus, it is considered that the reason why the sufficient PID resistance is obtained when the thickness of the silicon nitride film 7 is 30 nm or more, and, in particular, 50 nm or more is that almost all of the Na ions are captured inside the silicon nitride film 7 and are prevented from migrating to the semiconductor substrate 1 side through the silicon nitride film 7.

Another possible reason why the sufficient PID resistance is obtained when the thickness of the silicon nitride film 7 is 30 nm or more, and, in particular, 50 nm or more, is that the electric field applied to the silicon nitride film 7 is decreased, and diffusion of the Na ions into the silicon nitride film 7 can be effectively suppressed.

Typically, the magnitude of the electric field applied to the silicon nitride film 7 increases as the thickness of the silicon nitride film 7 decreases. When the thickness of the silicon nitride film 7 is set to 30 nm or more, and in particular 50 nm or more, the electric field applied to the silicon nitride film 7 can be decreased. Moreover, when the thickness of the silicon nitride film 7 is 110 nm or less and in particular 100 nm or less, the silicon nitride film 7 absorbs less incident light while reflection of the incident light at the surface of the silicon nitride film 7 is suppressed; thus, there is a tendency in which the properties of the back contact solar battery cell of the first embodiment, and the properties of the solar battery module that includes the cell can be improved.

Next, a high-frequency voltage is applied between the lower electrode 27 and an upper electrode 28. As a result, the silicon nitride film 7 can be formed on the light-receiving surface 1a of the semiconductor substrate 1. The dielectric film 6 on the back surface 1b of the semiconductor substrate 1 can be formed by the same manner as the silicon nitride film 7. A silicon oxide film, a silicon nitride film, or the like can be formed as the dielectric film 6.

Next, the dielectric film 6 on the back surface 1b of the semiconductor substrate 1 is partly removed so as to expose the n-type impurity-containing regions 2 and the p-type impurity-containing regions 3. The n-electrodes 4 are formed on the n-type impurity-containing regions 2, and the p-electrodes 5 are formed on the p-type impurity-containing regions 3 so as to produce the back contact solar battery cell 1 of the first embodiment illustrated in Fig. 1.

<Wiring sheet>

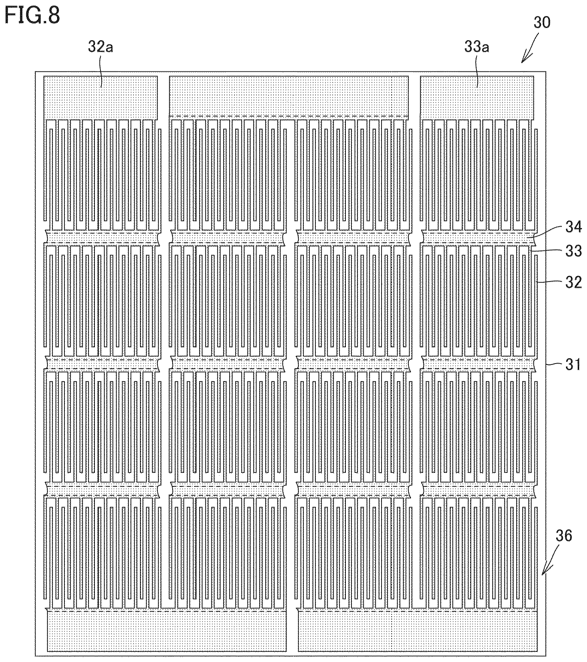

Fig. 8 is a schematic plan view of a surface of one example of a wiring sheet used in the solar battery module of the first embodiment. As illustrated in Fig. 8, a wiring sheet 30 has an insulating substrate 31, and wiring 36 on a surface of the insulating substrate 31. The wiring 36 includes n-wires 32, n-wires 32a, p-wires 33, p-wires 33a, and connection wires 34.

Here, the n-wires 32, the n-wires 32a, the p-wires 33, the p-wires 33a, and the connection wires 34 are electrically conductive. The n-wires 32 and the p-wires 33 are each configured to have a comb-shape that includes a shape in which multiple rectangles are aligned in a direction orthogonal to the longitudinal direction of the rectangles. The n-wires 32a, the p-wires 33a, and the connection wires 34 are strip-shaped. Furthermore, any n-wire 32a and any p-wire 33a adjacent to each other and other than the n-wire 32a and the p-wire 33a located at ends of the wiring sheet 30 are electrically coupled through the connection wire 34.

In the wiring sheet 30, the n-wires 32 and the p-wires 33 are arranged so that the portions corresponding to the comb teeth (rectangles) of the n-wires 32 having a comb shape and the portions corresponding to the comb teeth (rectangles) of the p-wires 33 having a comb shape are alternately interdigitated. As a result, the portions corresponding to the comb teeth (rectangles) of the n-wires 32 having a comb shape and the portions corresponding to the comb teeth (rectangles) of the p-wires 33 having a comb shape are alternately arranged with particular gaps therebetween. The number of portions, which correspond to the comb teeth of at least one of the n-wires 32 and the p-wires 33, in the alternating cycle is not limited to one and may be two or more.

<Installation of back contact solar battery cell>

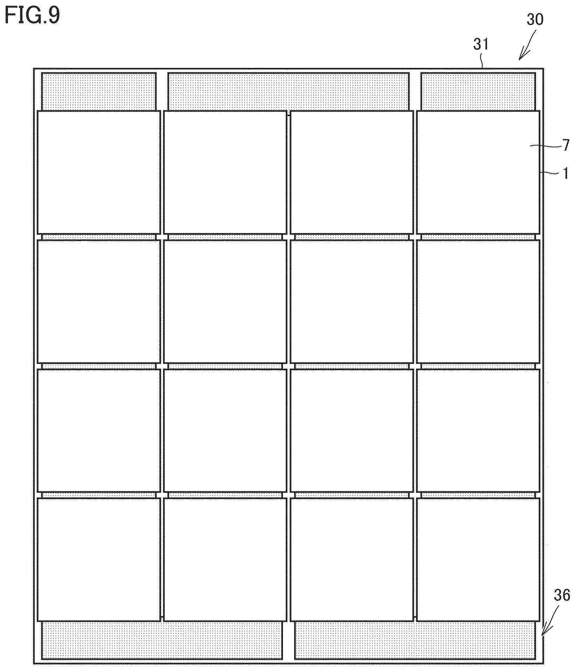

Fig. 9 is a schematic plan view illustrating a state in which the back contact solar battery cell of the first embodiment is installed on the wiring sheet 30 illustrated in Fig. 8. The back contact solar battery cell is installed on the wiring sheet 30 so that the back surface 1b side of the back contact solar battery cell and the installation side of the wiring 36 of the wiring sheet 30 face each other.

<Solar battery module>

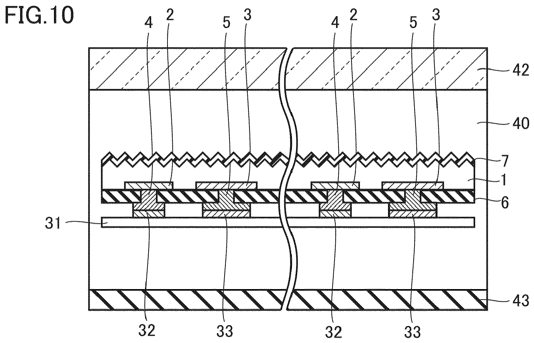

Fig. 10 is a schematic cross-sectional view of a solar battery module of the first embodiment. In the solar battery module of the first embodiment, the back contact solar battery cell of the first embodiment is connected to the wiring sheet 30 so that the n-electrodes 4 of the back contact solar battery cell of the first embodiment are electrically coupled to the n-wires 32 of the wiring sheet 30 and that the p-electrodes 5 of the back contact solar battery cell of the first embodiment are electrically coupled to the p-wires 33 of the wiring sheet 30.

In the solar battery module of the first embodiment, at least a glass substrate 42, a sealing material 40, and the back contact solar battery cell of the first embodiment are disposed in that order from the light-receiving-surface side. In the solar battery module of the first embodiment, the sealing material 40 and the glass substrate 42 are disposed on the light-receiving-surface side of the back contact solar battery cell of the first embodiment already connected to the wiring sheet 30. Moreover, sealing is performed so that the sealing material 40 and a back surface protection sheet 43 are disposed on the back surface side of the wiring sheet 30. For example, ethylene vinyl acetate (EVA) can be used as the sealing material 40 on the light-receiving-surface side of the back contact solar battery cell of the first embodiment.

The volume resistivity of the sealing material 40 on the light-receiving-surface side of the back contact solar battery cell of the first embodiment at 60°C is preferably $1 \times 10^{15}$ $\Omega$cm or less and more preferably $1 \times 10^{14}$ $\Omega$cm or less. When the volume resistivity of the sealing material 40 at 60°C is $1 \times 10^{15}$ $\Omega$cm or less, in particular, $1 \times 10^{14}$ $\Omega$cm or less, the bonding strength between the glass substrate 42 and the sealing material 40 in the solar battery module of the first embodiment can be improved while maintaining high PID resistance. A sealing material with a high volume resistivity has low gas absorbing power, and thus gas generated from the sealing material and other parts during temperature elevation cannot be absorbed and remains at the interfaces in some cases. When the volume resistivity is $1 \times 10^{15}$ $\Omega$cm or less, degradation of the bonding strength by the gas at the interfaces can be prevented.

Moreover, when a back contact solar battery cell electrically connected to the wires of the wiring sheet 30 is used, the bonding strength between the wiring sheet 30 and the sealing material 40 can also be improved. In addition, since the cost for the material for the sealing material 40 can be decreased, the cost of the solar battery module of the first embodiment can be decreased.

The volume resistivity of the sealing material 40 on the light-receiving-surface side of the back contact solar battery cell of the first embodiment at 60°C is preferably $1 \times 10^{11}$ $\Omega$cm or more and more preferably $1 \times 10^{12}$ $\Omega$cm or more. When the volume resistivity of the sealing material 40 at 60°C is $1 \times 10^{11}$ $\Omega$cm or more, in particular, $1 \times 10^{12}$ $\Omega$cm or more, the PID resistance of the solar battery module of the first embodiment tends to improve. More specifically, the back contact solar battery cell of the first embodiment can prevent migration of Na ions into the semiconductor substrate 1 even when an electric field is applied to the silicon nitride film 7 disposed on the light-receiving-surface side and the Na ions have gained driving power to diffuse into the silicon nitride film 7. In addition, by increasing the volume resistivity of the sealing material 40 and by decreasing the electric field applied to the silicon nitride film 7, the driving power of the Na ions diffusing into the silicon nitride film 7 can be decreased. Thus, the PID resistance of the solar battery module of the first embodiment can be further improved.

Studies have found that when the voltage applied to the silicon nitride film 7 is 3 V or less, it can be deemed that the electric field does not act as driving power that causes Na ions to diffuse into the silicon nitride film 7.

The volume resistivity of the sealing material 40 on the light-receiving-surface side of the back contact solar battery cell of the first embodiment at 60°C is preferably $1 \times 10^{11}$ $\Omega$cm or more and $1 \times 10^{15}$ $\Omega$cm or less, and more preferably $1 \times 10^{-2}$ $\Omega$cm or more and $1 \times 10^{15}$ $\Omega$cm or less. When the volume resistivity of the sealing material 40 at 60°C is $1 \times 10^{11}$ $\Omega$cm or more and $1 \times 10^{15}$ $\Omega$cm or less, in particular, $1 \times 10^{12}$ $\Omega$cm or more and $1 \times 10^{15}$ $\Omega$cm or less, the bonding strength between the glass substrate 42 and the sealing material 40 in the solar battery module of the first embodiment can be improved while maintaining high PID resistance. Moreover, when a back contact solar battery cell electrically connected to the wires of the wiring sheet 30 is used, the bonding strength between the wiring sheet 30 and the sealing material 40 can also be improved. In addition, since the cost for the material for the sealing material 40 can be decreased, the cost of the solar battery module of the first embodiment can be decreased.

<Calculation 1>

The conditions of calculation 1 were as follows: the thickness of the glass substrate 42 was 3 mm, the thickness of the silicon nitride film 7 was 100 nm, and the thickness of the sealing material 40 on the light-receiving-surface side of the back contact solar battery cell of the first embodiment was 400 $\mu$m. The conditions of calculation 1 also included that a voltage of 600 V was applied between the glass substrate 42 and the silicon nitride film 7 via the sealing material 40 on the light-receiving-surface side, where the resistance value of the glass substrate 42 per 1 cm$^2$ area at 60°C was

$3 \times 10^{10}$ Ω, and the resistance value of the silicon nitride film 7 per 1 cm$^2$ area at 60°C was $1 \times 10^8$ Ω. Under the conditions of calculation 1 and in an environment at a temperature of 60°C, the volume resistivity [Ωcm] and the resistance value of [Ω] of the sealing material 40 on the light-receiving-surface side of the back contact solar battery cell of the first embodiment at 60°C, the current density [A/cm$^2$] of the current flowing in the glass substrate 42, the sealing material 40 on the light-receiving-surface side, and the silicon nitride film 7, and the voltage [V] applied to the silicon nitride film 7 were checked.

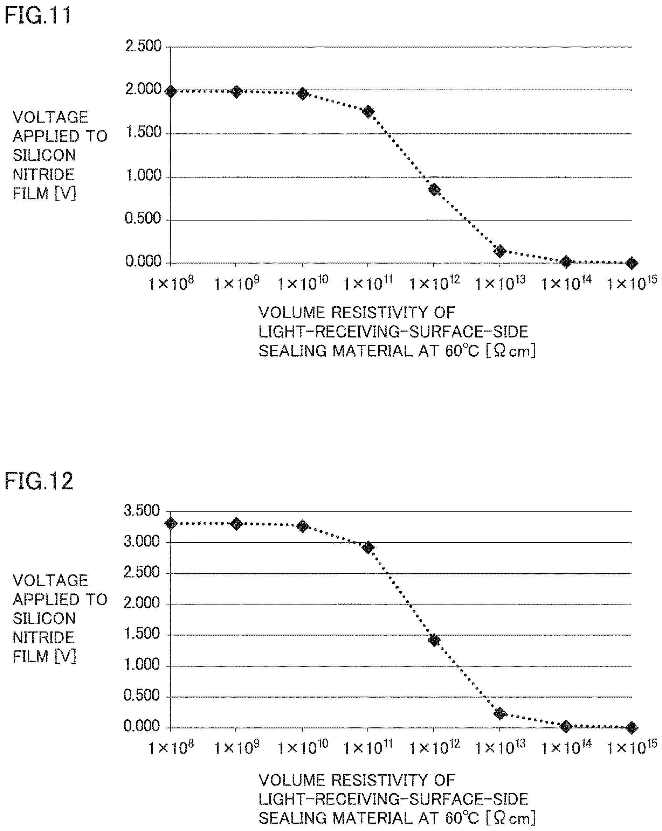

The results are indicated in Table 1. The relationship between the volume resistivity [Ωcm] of the sealing material 40 on the light-receiving-surface side at 60°C and the voltage [V] applied to the silicon nitride film 7 indicated in Table 1 is indicated in Fig. 11. The horizontal axis in Fig. 11 indicates the volume resistivity [Ωcm] of the sealing material 40 on the light-receiving-surface side at 60°C, and the vertical axis indicates the voltage [V] applied to the silicon nitride film 7.

[Table 1]

| Volume resistivity [Ωcm] of sealing material on light-receiving-surface side at 60°C | Resistance value [Ω] of sealing material on light-receiving-surface side at 60°C | Current density [A/cm$^2$] | Voltage [V] applied to silicon nitride film |
|---|---|---|---|
| $1\times10^8$ | $4\times10^6$ | $1.99\times10^{-8}$ | 1.993 |
| $1\times10^9$ | $4\times10^7$ | $1.99\times10^{-8}$ | 1.991 |
| $1\times10^{10}$ | $4\times10^8$ | $1.97\times10^{-8}$ | 1.967 |
| $1\times10^{11}$ | $4\times10^9$ | $1.76\times10^{-8}$ | 1.760 |
| $1\times10^{12}$ | $4\times10^{10}$ | $8.56\times10^{-9}$ | 0.856 |
| $1\times10^{13}$ | $4\times10^{11}$ | $1.40\times10^{-9}$ | 0.140 |
| $1\times10^{14}$ | $4\times10^{12}$ | $1.49\times10^{-10}$ | 0.015 |
| $1\times10^{15}$ | $4\times10^{13}$ | $1.50\times10^{-11}$ | 0.001 |

Under the conditions of calculation 1, the voltage [V] applied to the silicon nitride film 7 indicated in Table 1 and Fig. 11 was less than 2 V in all cases. Under the conditions of calculation 1, when the volume resistivity [Ωcm] of the sealing material 40 on the light-receiving-surface side of the back contact solar battery cell of the first embodiment at 60°C is $1 \times 10^{15}$ Ωcm or less, more stable, higher PID resistance can be obtained.

<Calculation 2>

The conditions of calculation 2 were the same as the conditions of calculation 1 except that a voltage of 1000 V was applied between the glass substrate 42 and the silicon nitride film 7 via the sealing material 40 on the light-receiving-surface side. Under the conditions of calculation 2, the volume resistivity [Ωcm] and the resistance value of [Ω] of the sealing material 40 on the light-receiving-surface side of the back contact solar battery cell of the first embodiment at 60°C, the current density [A/cm$^2$] of the current flowing in the glass substrate 42, the sealing material 40 on the light-receiving-surface side, and the silicon nitride film 7, and the voltage [V] applied to the silicon nitride film 7 were checked as in calculation 2. The results are indicated in Table 2. The relationship between the volume resistivity [Ωcm] of the sealing material 40 on the light-receiving-surface side at 60°C and the voltage [V] applied to the silicon nitride film 7 indicated in Table 2 is indicated in Fig. 12. The horizontal axis in Fig. 12 indicates the volume resistivity [Ωcm] of the sealing material 40 on the light-receiving-surface side at 60°C, and the vertical axis indicates the voltage [V] applied to the silicon nitride film 7.

[Table 2]

| Volume resistivity [Ωcm] of sealing material on light-receiving-surface side at 60°C | Resistance value [Ω] of sealing material on light-receiving-surface side at 60°C | Current density [A/cm$^2$] | Voltage [V] applied to silicon nitride film |
|---|---|---|---|
| $1\times10^8$ | $4\times10^6$ | $3.32\times10^{-8}$ | 3.322 |
| $1\times10^9$ | $4\times10^7$ | $3.32\times10^{-8}$ | 3.318 |
| $1\times10^{10}$ | $4\times10^8$ | $3.28\times10^{-8}$ | 3.279 |
| $1\times10^{11}$ | $4\times10^9$ | $2.93\times10^{-8}$ | 2.933 |

(continued)

| Volume resistivity [Ωcm] of sealing material on light-receiving-surface side at 60°C | Resistance value [Ω] of sealing material on light-receiving-surface side at 60°C | Current density [A/cm²] | Voltage [V] applied to silicon nitride film |
|---|---|---|---|
| $1\times10^{12}$ | $4\times10^{10}$ | $1.43\times10^{-8}$ | 1.427 |
| $1\times10^{13}$ | $4\times10^{11}$ | $2.33\times10^{-9}$ | 0.233 |
| $1\times10^{14}$ | $4\times10^{12}$ | $2.48\times10^{-10}$ | 0.025 |
| $1\times10^{15}$ | $4\times10^{13}$ | $2.50\times10^{-11}$ | 0.002 |

Under the conditions of calculation 2, as indicated by Table 2 and Fig. 12, when the volume resistivity [Ωcm] of the sealing material 40 on the light-receiving-surface side at 60°C was $1 \times 10^{11}$ Ωcm or more, the voltage [V] applied to the silicon nitride film 7 was less than 3 V. This shows that when the volume resistivity [Ωcm] of the sealing material 40 on the light-receiving-surface side at 60°C is $1 \times 10^{11}$ Ωcm or more, stable high PID resistance can be obtained.

<Calculation 3>

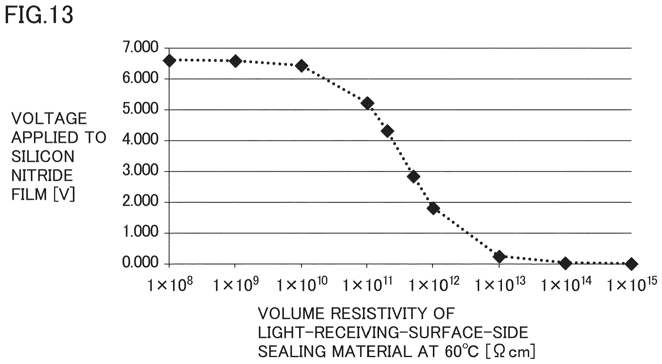

In calculation 3, the volume resistivity [Ωcm] and the resistance value of [Ω] of the sealing material 40 on the light-receiving-surface side of the back contact solar battery cell of the first embodiment at 70°C, the current density [A/cm²] of the current flowing in the glass substrate 42, the sealing material 40 on the light-receiving-surface side, and the silicon nitride film 7, and the voltage [V] applied to the silicon nitride film 7 were checked as in calculation 3 except that the environment had a temperature of 70°C. The results are indicated in Table 3. The relationship between the volume resistivity [Ωcm] of the sealing material 40 on the light-receiving-surface side at 60°C and the voltage [V] applied to the silicon nitride film 7 indicated in Table 3 is indicated in Fig. 13. The horizontal axis in Fig. 13 indicates the volume resistivity [Ωcm] of the sealing material 40 on the light-receiving-surface side at 60°C, and the vertical axis indicates the voltage [V] applied to the silicon nitride film 7. It should be noted that the volume resistivity of the sealing material 40 and the volume resistivity of the glass substrate 42 at 70°C are each 1/2 of the corresponding volume resistivity at 60°C; thus, the volume resistivity [Ωcm] of the sealing material 40 on the light-receiving-surface side at 60°C indicated in Fig. 13 is the value obtained by doubling the volume resistivity [Ωcm] at 70°C.

[Table 3]

| Volume resistivity [Ωcm] of sealing material on light-receiving-surface side at 70°C | Resistance value [Ω] of sealing material on light-receiving-surface side at 60°C | Current density [A/cm²] | Voltage [V] applied to silicon nitride film |
|---|---|---|---|
| $1\times10^{8}$ | $4\times10^{6}$ | $6.62\times10^{-8}$ | 6.621 |
| $1\times10^{9}$ | $4\times10^{7}$ | $6.61\times10^{-8}$ | 6.605 |
| $1\times10^{10}$ | $4\times10^{8}$ | $6.45\times10^{-8}$ | 6.452 |
| $1\times10^{11}$ | $4\times10^{9}$ | $5.24\times10^{-8}$ | 5.236 |
| $2\times10^{11}$ | $8\times10^{9}$ | $4.33\times10^{-8}$ | 4.329 |
| $5\times10^{11}$ | $2\times10^{10}$ | $2.85\times10^{-8}$ | 2.849 |
| $1\times10^{12}$ | $4\times10^{10}$ | $1.81\times10^{-8}$ | 1.815 |
| $1\times10^{13}$ | $4\times10^{11}$ | $2.41\times10^{-9}$ | 0.241 |
| $1\times10^{14}$ | $4\times10^{12}$ | $2.49\times10^{-10}$ | 0.025 |
| $1\times10^{15}$ | $4\times10^{13}$ | $2.50\times10^{-11}$ | 0.002 |

Under the conditions of calculation 3, as indicated by Table 3 and Fig. 13, when the volume resistivity [Ωcm] of the sealing material 40 on the light-receiving-surface side at 70°C was $5 \times 10^{11}$ Ωcm or more, the voltage [V] applied to the silicon nitride film 7 was less than 3 V. This shows that when the volume resistivity [Ωcm] of the sealing material 40 on the light-receiving-surface side at 70°C is $5 \times 10^{11}$ Ωcm or more, stable high PID resistance can be obtained. As a result, it is considered that, when the volume resistivity [Ωcm] of the sealing material 40 on the light-receiving-surface side at 60°C is $1 \times 10^{12}$ $\Omega$cm or more, more stable high PID resistance can be obtained. As mentioned above, the back contact solar battery cell of the first embodiment itself has high PID resistance since the nitrogen mass ratio in the silicon nitride film 7 is 0.38 or more, preferably 0.28 or more and 0.38 or less, and more preferably 0.30 or more and 0.36 or less; thus, the back contact solar battery cell of the first embodiment can itself maintain high PID resistance. Thus, a solar battery module of the first embodiment that includes the back contact solar battery cell of the first embodiment can also maintain high PID resistance. Furthermore, since the volume resistivity of the sealing material 40 on the light-receiving-surface side is specified, a solar battery module of the first embodiment in which the bonding strength between the glass substrate 42 and the sealing material 40 is high can be obtained. In addition, there is a secondary effect in that since the sealing material 40 is less expensive, the cost of the solar battery module of the first embodiment can be decreased.

In the description above, a solar battery module using a wiring sheet has been described; however, the solar battery module using the wiring sheet is not limiting, and the solar battery module may be the one that does not use a wiring sheet as long as the back contact solar battery cell having the PID resistance by itself is included.

In the description above, the case in which the sealing material 40, which is formed of EVA or the like having low resistance value and moderate PID resistance is used as the sealing material 40; alternatively, an olefin-based sealing material having a high resistance value and high PID resistance can be used. In such a case, the PID resistance of the solar battery module can be further improved.

<Solar power generation system>

A solar power generation system of the first embodiment includes the solar battery module of the first embodiment. The solar power generation system of the first embodiment can be configured by placing multiple solar battery modules of the first embodiment and connecting the solar battery modules with wires in series and/or parallel. The solar battery modules of the first embodiment constituting the solar power generation system of the first embodiment can respectively be installed on mounts, and the mounts can be fixed to earth.

The two ends of the solar battery modules of the first embodiment connected in series to configure the solar power generation system of the first embodiment may be grounded with appropriate resistors in between, or the entirety of the solar battery modules of the first embodiment may be insulated from the outside circuit. Since the solar battery module of the first embodiment itself has the PID resistance, any desired grounding method can be employed.

[Second embodiment]

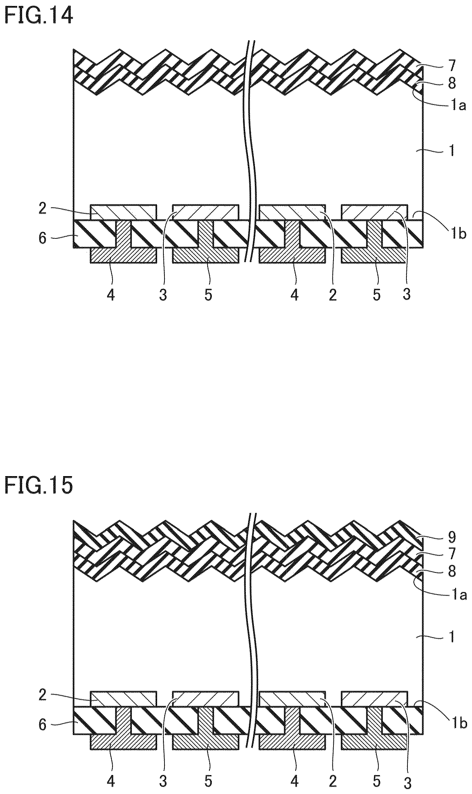

Fig. 14 is a schematic cross-sectional view of a back contact solar battery cell according to a second embodiment. The back contact solar battery cell of the second embodiment is characterized in that a second silicon nitride film 8 and a silicon nitride film 7 are stacked on a light-receiving surface 1a of a semiconductor substrate 1 in that order, and the second silicon nitride film 8 is positioned between the light-receiving surface 1a of the semiconductor substrate 1 and the silicon nitride film 7.

The back contact solar battery cell of the second embodiment has high PID resistance since the silicon nitride film 7 is disposed on the light-receiving-surface side of the back contact solar battery cell compared to the second silicon nitride film 8. Moreover, the second silicon nitride film 8 can be a film having a low nitrogen mass ratio in the silicon nitride film compared to the silicon nitride film 7. The nitrogen mass ratio in the second silicon nitride film 8 is preferably 0.21 or less. When the nitrogen mass ratio in the second silicon nitride film 8 is 0.21 or less, the second silicon nitride film 8 can improve the passivation property of the light-receiving surface 1a of the semiconductor substrate 1, and higher PID resistance tends to be obtained.

The thickness of the second silicon nitride film 8 is preferably 3 nm or more and 10 nm or less. When the thickness of the second silicon nitride film 8 is 3 nm or more and 10 nm or less, higher PID resistance tends to be obtained.

In the second embodiment, the second silicon nitride film 8 disposed on the light-receiving surface 1a of the semiconductor substrate 1 improves the passivation property of the light-receiving surface 1a of the semiconductor substrate 1, and thus, it becomes possible to extend the lifetime of minority carriers in the back contact solar battery cell of the second embodiment. As a result, the open circuit voltage value of the back contact solar battery cell can be improved, and the conversion efficiency can be further enhanced.

Furthermore, the reflection of the incident light at the interface between the silicon nitride film 7 and the second silicon nitride film 8 can be suppressed by setting the nitrogen mass ratio in the second silicon nitride film 8 to be lower than the nitrogen mass ratio in the silicon nitride film 7. As a result, the short circuit current value of the back contact solar battery cell of the second embodiment can be improved, and the conversion efficiency can be further enhanced.

The rest of the second embodiment is the same as the first embodiment, and the descriptions therefor are omitted.

[Third embodiment]

Fig. 15 is a schematic cross-sectional view of a back contact solar battery cell according to a third embodiment. The back contact solar battery cell of the third embodiment is characterized in that a second silicon nitride film 8, a silicon nitride film 7, and a third silicon nitride film 9 are stacked on a light-receiving surface 1a of a semiconductor substrate 1 in that order, and the silicon nitride film 7 is positioned between the second silicon nitride film 8 and the third silicon nitride film 9.

In the third embodiment, film deposition is performed so that the nitrogen mass ratio in the silicon nitride film 7 is 0.32, and the thickness is 50 nm. Furthermore, in the third embodiment, the nitrogen mass ratio in the third silicon nitride film 9 is larger than the nitrogen mass ratio in the silicon nitride film 7, and the nitrogen mass ratio in the silicon nitride film 7 is larger than the nitrogen mass ratio in the second silicon nitride film 8. In the back contact solar battery cell of the third embodiment, since three silicon nitride films are formed on the light-receiving surface 1a of the semiconductor substrate 1, the reflection at the light-receiving surface 1a of the semiconductor substrate 1 can be further suppressed compared to the back contact solar battery cell of the second embodiment. Thus, the back contact solar battery cell of the third embodiment can have higher conversion efficiency than the back contact solar battery cell of the second embodiment.

The rest of the third embodiment is the same as the first embodiment, and the descriptions therefor are omitted.

In this embodiment, the case in which three silicon nitride films are formed on a semiconductor substrate is described, but the number of layers is not limited to three. An additional layer may be disposed between the second silicon nitride film 8 and the silicon nitride film 7 or between the silicon nitride film 7 and the third silicon nitride film 9. For example, when a layer in which the nitrogen mass ratio changes in a graded manner is provided, the conversion efficiency of the solar battery cell can be improved. This is because reflection at the interfaces can be suppressed, and the short circuit current value can be improved.

EXAMPLES

[EXAMPLE 1]

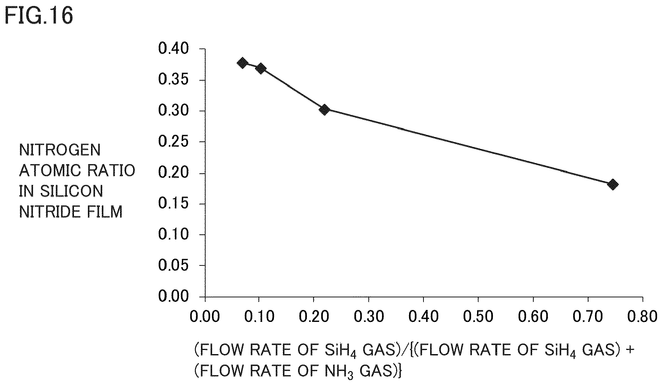

Back contact solar battery cells (the semiconductor substrate 1 was an n-type single crystal silicon substrate) of Example having the same structure as the back contact solar battery cell of the second embodiment illustrated in Fig. 14 were prepared. The back contact solar battery cells of Example were prepared in such a manner that the second silicon nitride film 8 was formed under the same conditions, but the flow rate of the $SiH_4$ gas and the flow rate of the $NH_3$ gas during formation of the silicon nitride film 7 on the second silicon nitride film 8 was different from one another so that the nitrogen mass ratio in the silicon nitride film 7 was different from one another. Fig. 16 shows the relationship between the ratio of the flow rate of the $SiH_4$ gas to the sum of the flow rate of the $SiH_4$ gas and the flow rate of the $NH_3$ gas during formation of the silicon nitride film 7, and the nitrogen mass ratio in the silicon nitride film 7. The horizontal axis in Fig. 16 indicates the ratio regarding the flow rate of the $SiH_4$ gas and the flow rate of the $NH_3$ gas ((flow rate of $SiH_4$ gas)/{(flow rate of $SiH_4$ gas) + (flow rate of $NH_3$ gas)}), and the vertical axis in Fig. 16 indicates the nitrogen mass ratio in the silicon nitride film 7.

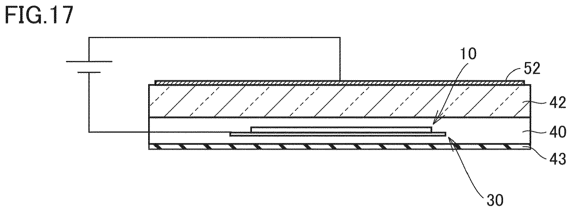

Next, as illustrated in the schematic diagram of Fig. 17, each of the back contact solar battery cells 10 of Example prepared as described above was placed on the wiring sheet 30, and sealed within the sealing material 40 formed of EVA placed between the glass substrate 42 and the back surface protection sheet 43, which was formed of a PET film with an aluminum film deposited thereon. As a result, the glass substrate 42, the sealing material 40, and the back contact solar battery cell of Example were disposed in that order from the light-receiving-surface side.

<Simulated positive electrode grounding test: Case in which the glass substrate 42 was set at 0 V and the back contact solar battery cell 10 was set at a negative high voltage>

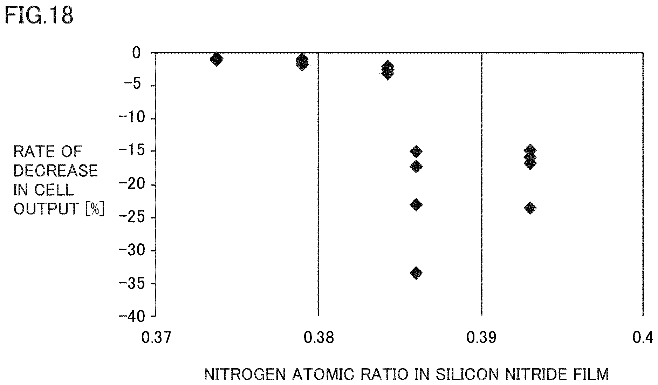

Next, as illustrated in Fig. 17, a simulated positive electrode grounding test was performed, in which a simulated positive electrode 52 formed of a copper foil was formed on a surface of the glass substrate 42 and then grounded, and the battery cell was left in a 60°C environment for 96 hours while a voltage of -600 V was applied to the back contact solar battery cell 10, and the rate of decrease in cell output before and after the simulated positive electrode grounding test was calculated. The results are indicated in Fig. 18. The horizontal axis in Fig. 18 indicates the nitrogen mass ratio in the silicon nitride film 7 of the back contact solar battery cell of Example, and the vertical axis in Fig. 18 indicates the rate of decrease [%] in cell output before and after the simulated positive electrode grounding test. The rate of decrease [%] in cell output before and after the simulated positive electrode grounding test is calculated from formula (1) below:

$$\text{Rate of decrease [\%] in cell output before and after}$$
$$\text{simulated positive electrode grounding test} = 100 \times \{\text{(cell}$$
$$\text{output after simulated positive electrode grounding test)} -$$
$$\text{(cell output before simulated positive electrode grounding}$$
$$\text{test)}\}/\text{(cell output before simulated positive electrode}$$
$$\text{grounding test)} \quad (1)$$

As illustrated in Fig. 18, it was confirmed that the rate of decrease in cell output before and after the simulated positive electrode grounding test can be suppressed when the nitrogen mass ratio in the silicon nitride film 7 of the back contact solar battery cell of Example is within the range of 0.38 or less.

The reason why the rate of decrease in cell output before and after the simulated positive electrode grounding test can be suppressed is presumably as follows. When a voltage is applied to the solar battery module, Na ions pass through the sealing material 40 and migrate toward the back contact solar battery cell. A silicon nitride film is usually a mixture of microcrystal phases and amorphous phases, and it is known that the proportion of the amorphous phases increases and the proportion of the microcrystal phases decreases as the silicon mass ratio increases. The Na ions that have entered the silicon nitride film are thought to propagate through crystal/amorphous interphases. The crystal/amorphous interphases that mediate the Na ion conduction decrease and the Na ions cannot smoothly migrate when the nitrogen mass ratio in the silicon nitride film is decreased (that is, the silicon content in the silicon nitride film is relatively increased). In other words, it becomes possible to prevent the Na ions from reaching the surface of the semiconductor substrate, which is composed of n-type single crystal silicon, and forming defects near the surface.

Thus, it is considered that by adjusting the nitrogen mass ratio in the silicon nitride film to 0.38 or less, the rate of decrease in cell output before and after the simulated positive electrode grounding test can be suppressed.

[EXAMPLE 2]

Back contact solar battery cells of Example having a similar structure to the back contact solar battery cell of the second embodiment illustrated in Fig. 14 were prepared. As in Example 1, the back contact solar battery cells of Example were prepared in such a manner that the second silicon nitride film 8 was formed under the same conditions, but the nitrogen mass ratio in the silicon nitride film 7 was different from one another. The nitrogen mass ratio in the second silicon nitride film 8 was 0.18.

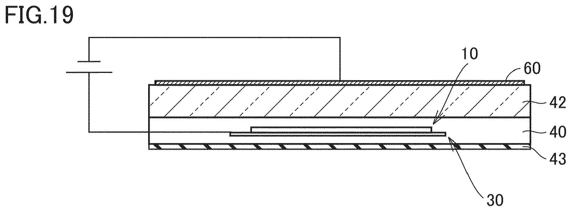

Next, as illustrated in the schematic diagram of Fig. 19, each of the back contact solar battery cells 10 of Example prepared as described above was placed on the wiring sheet 30, and sealed within the sealing material 40 formed of EVA placed between the glass substrate 42 and the back surface protection sheet 43, which was formed of a PET film with an aluminum film deposited thereon. As a result, the glass substrate 42, the sealing material 40, and the back contact solar battery cell 10 were disposed in that order from the light-receiving-surface side.

<Simulated negative electrode grounding test: Case in which the glass substrate 42 was set at 0 V and the back contact solar battery cell 10 was set at a positive high voltage>

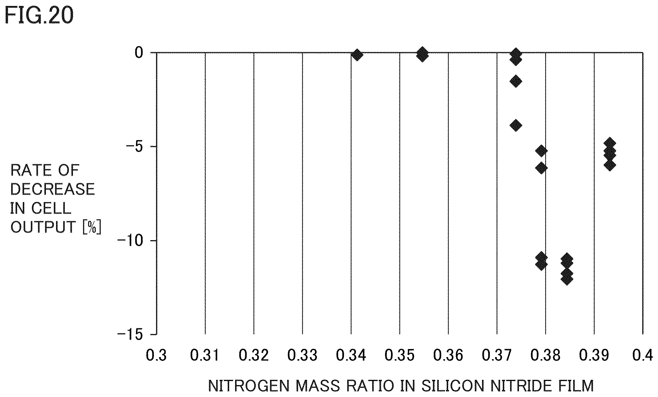

Next, as illustrated in Fig. 19, a simulated negative electrode grounding test was performed, in which a simulated negative electrode 60 formed of a copper foil was formed on a surface of the glass substrate 42 and then grounded, and the battery cell was left in a 60°C environment for 96 hours while a voltage of +600 V was applied to the back contact solar battery cell 10, and the rate of decrease in cell output before and after the simulated negative electrode grounding test was calculated. The results are indicated in Fig. 20. The horizontal axis indicates the nitrogen mass ratio in the silicon nitride film 7 of the back contact solar battery cell of Example, and the vertical axis indicates the rate of decrease [%] in cell output before and after the simulated negative electrode grounding test. The rate of decrease [%] in cell output before and after the simulated negative electrode grounding test is calculated from formula (2) below:

Rate of decrease [%] in cell output before and after simulated negative electrode grounding test = 100 × {(cell output after simulated negative electrode grounding test) – (cell output before simulated negative electrode grounding test)}/(cell output before simulated negative electrode grounding test)    (2)

As illustrated in Fig. 20, it was confirmed that the rate of decrease in cell output before and after the simulated negative electrode grounding test can be suppressed when the nitrogen mass ratio in the silicon nitride film of the back contact solar battery cell of Example is within the range of 0.37 or less.

The reason why the rate of decrease in cell output before and after the simulated negative electrode grounding test can be suppressed when the nitrogen mass ratio in the silicon nitride film is within the range of 0.37 or less is presumably as follows. When a voltage is applied to the solar battery module, electrons migrate toward the back contact solar battery cell. It is known that as the nitrogen mass ratio in a silicon nitride film of a back contact solar battery cell decreases (as the silicon mass ratio increases), the density of defects that trap electrons decreases and the charge retaining ability is lowered. In other words, the larger the nitrogen mass ratio in the silicon nitride film, the higher the ability of the film to trap electrons.

A sufficient amount of electrons are trapped in a silicon nitride film having a nitrogen mass ratio of 0.37 or more in the film; however, since the nitrogen mass ratio in the second silicon nitride film is 0.37 or less, not many electrons will be trapped in this layer. Presumably, since negative charging is suppressed near the semiconductor substrate, the influence on the surface recombination velocity (positive fixed charges) is suppressed, and thus the decrease in output of the solar battery cell rarely occurs.

[EXAMPLE 3]

Back contact solar battery cells of Example having a similar structure to the back contact solar battery cell of the third embodiment illustrated in Fig. 15 were prepared. The back contact solar battery cell of the third embodiment is characterized in that a second silicon nitride film 8, a silicon nitride film 7, and a third silicon nitride film 9 are stacked on a light-receiving surface 1a of a semiconductor substrate 1 in that order. The back contact solar battery cells of Example were prepared in such a manner that the second silicon nitride film 8 and the third silicon nitride film were formed under the same conditions, but the nitrogen mass ratio in the silicon nitride film 7 was different from one another. The nitrogen mass ratio in the second silicon nitride film 8 was 0.18, and the nitrogen mass ratio in the third silicon nitride film 9 was 0.39. Deposition was performed so that the second silicon nitride film 8, the silicon nitride film 7, and the third silicon nitride film had thicknesses of 5 nm, 40 nm, and 50 nm, respectively.

The simulated negative electrode grounding test and the method for calculating the rate of decrease in cell output before and after the simulated negative electrode grounding test are the same as in Example 2. The detailed descriptions are thus omitted.

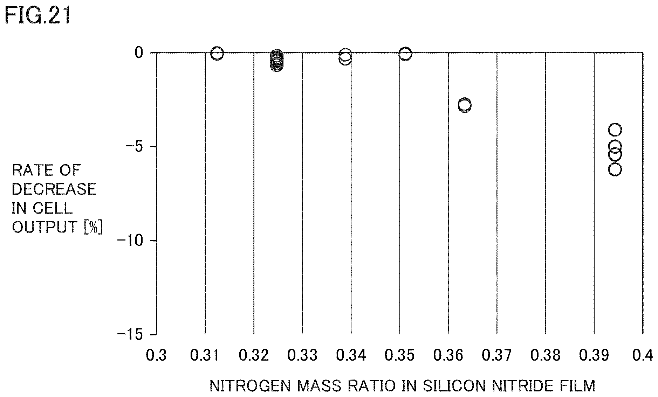

Fig. 21 indicates the rate of decrease in cell output after the simulated negative electrode grounding test. The horizontal axis indicates the mass ratio in the silicon nitride film 7 of the back contact solar battery cell of Example, and the vertical axis indicates the rate of decrease [%] in cell output before and after the simulated negative electrode grounding test. As illustrated in Fig. 21, it was confirmed that the rate of decrease in cell output before and after the simulated negative electrode grounding test can be suppressed when the nitrogen mass ratio in the silicon nitride film 7 of the back contact solar battery cell of Example is within the range of 0.35 or less. Presumably, in the simulated negative electrode grounding test, many electrons were trapped in the outermost silicon nitride film 9 having the highest nitrogen atom ratio in the silicon nitride film. Since the third silicon nitride film 9 is sufficiently distant from the semiconductor substrate 1, the surface recombination velocity is rarely affected by the silicon nitride film 9 trapping the electrons. Meanwhile, the second silicon nitride film 8, which is closest to the semiconductor substrate 1, has the lowest nitrogen atom ratio in the silicon nitride film and is relatively thin compared to the silicon nitride film 7 and the third silicon nitride film 9; thus, electrons are rarely trapped in the second silicon nitride film 8. Furthermore, although the silicon nitride film 7 is relatively thick, electrons are rarely trapped since the nitrogen mass ratio in the film is 0.35 or less. It is presumed that since negative charging is suppressed near the semiconductor substrate, the influence on the surface recombination velocity (positive fixed charges) is suppressed, and the decrease in output of the solar battery cell is suppressed.

Although the embodiments and examples of the present invention have been described above, appropriately combining features of the embodiments and the examples is within the expected range. The embodiments and examples disclosed herein are merely illustrative in all respects and should not be considered as limiting. The scope of the present invention is defined not by the descriptions above but by the claims and is intended to include all modifications and alterations within the meaning and the scope of the claims and their equivalents.

Industrial Applicability

The embodiments disclosed herein can be used in back contact solar battery cells, solar battery modules that include back contact solar battery cells, and solar power generation systems.

Reference Signs List

1 semiconductor substrate, 1a light-receiving-surface, 1b back surface, 2 n-type impurity-containing region, 3 p-type impurity-containing region, 4 n-electrode, 5 p-electrode, 6 dielectric film, 7 silicon nitride film, 8 second silicon nitride film, 9 third silicon nitride film, 10 back contact solar battery cell, 21 texture mask, 22 diffusing mask, 22a opening, 23, 24, 25 diffusing mask, 25a opening, 26 deposition chamber, 27 lower electrode, 28 upper electrode, 29 gas inlet port, 30 wiring sheet, 31 insulating substrate, 32, 32a n-wire, 33, 33a p-wire, 34 connection wiring, 36 wiring, 40 sealing material, 42 glass substrate, 43 back surface protection sheet, 52 simulated positive electrode, 60 simulated negative electrode

**Claims**

1. A back contact solar battery cell comprising:

   a semiconductor substrate of a first or second conductivity type;
   a first-conductivity-type impurity-containing region and a second-conductivity-type impurity-containing region formed in a first surface of the semiconductor substrate; and
   a silicon nitride film on a second surface of the semiconductor substrate, the second surface being on the opposite side of the first surface,
   wherein the silicon nitride film has a nitrogen mass ratio of 0.38 or less.

2. The back contact solar battery cell according to Claim 1, further comprising a second silicon nitride film between the semiconductor substrate and the silicon nitride film.

3. The back contact solar battery cell according to Claim 2, wherein the silicon nitride film has a nitrogen mass ratio of 0.37 or less.

4. The back contact solar battery cell according to Claim 2, comprising the second silicon nitride film, the silicon nitride film, and a third silicon nitride film that are disposed on the second surface of the semiconductor substrate in that order.

5. The back contact solar battery cell according to Claim 4, wherein the silicon nitride film has a nitrogen mass ratio of 0.35 or less.

6. A solar battery module wherein:

   at least a glass substrate, a sealing material, and the back contact solar battery cell according to any one of Claims 1 to 5 are disposed in that order from a light-receiving-surface side,
   the back contact solar battery cell is arranged so that the second surface is disposed on the light-receiving-surface side, and
   the sealing material has a volume resistivity of $1 \times 10^{15}$ Ωcm or less at 60°C.

7. The solar battery module according to Claim 6, wherein a wiring sheet is disposed on a side close to the first surface of the back contact solar battery cell.

8. A solar power generation system comprising the solar battery module according to Claim 6 or 7.

FIG.1

FIG.2

FIG.3

FIG.4

FIG.5

FIG.6

FIG.7

FIG.8

FIG.9

FIG.10

FIG.11

VOLTAGE APPLIED TO SILICON NITRIDE FILM [V]

VOLUME RESISTIVITY OF LIGHT-RECEIVING-SURFACE-SIDE SEALING MATERIAL AT 60°C [Ω cm]

FIG.12

VOLTAGE APPLIED TO SILICON NITRIDE FILM [V]

VOLUME RESISTIVITY OF LIGHT-RECEIVING-SURFACE-SIDE SEALING MATERIAL AT 60°C [Ω cm]

## FIG.13

VOLTAGE APPLIED TO SILICON NITRIDE FILM [V] (y-axis)

VOLUME RESISTIVITY OF LIGHT-RECEIVING-SURFACE-SIDE SEALING MATERIAL AT 60°C [$\Omega$ cm] (x-axis)

FIG.14

FIG.15

FIG.16

NITROGEN
ATOMIC RATIO
IN SILICON
NITRIDE FILM

(FLOW RATE OF SiH$_4$ GAS)/{(FLOW RATE OF SiH$_4$ GAS) +
(FLOW RATE OF NH$_3$ GAS)}

FIG.17

FIG.18

NITROGEN ATOMIC RATIO IN SILICON NITRIDE FILM

FIG.19

FIG.20

RATE OF
DECREASE
IN CELL
OUTPUT [%]

NITROGEN MASS RATIO IN SILICON NITRIDE FILM

## FIG.21

RATE OF DECREASE IN CELL OUTPUT [%] (y-axis: 0, −5, −10, −15)

NITROGEN MASS RATIO IN SILICON NITRIDE FILM (x-axis: 0.3, 0.31, 0.32, 0.33, 0.34, 0.35, 0.36, 0.37, 0.38, 0.39, 0.4)

## INTERNATIONAL SEARCH REPORT

| International application No. |
|---|
| PCT/JP2017/007488 |

**A. CLASSIFICATION OF SUBJECT MATTER**
*H01L31/0216*(2014.01)i, *H01L31/048*(2014.01)i

According to International Patent Classification (IPC) or to both national classification and IPC

**B. FIELDS SEARCHED**

Minimum documentation searched (classification system followed by classification symbols)
H01L31/0216, H01L31/048

Documentation searched other than minimum documentation to the extent that such documents are included in the fields searched
Jitsuyo Shinan Koho          1922–1996   Jitsuyo Shinan Toroku Koho    1996–2017
Kokai Jitsuyo Shinan Koho   1971–2017   Toroku Jitsuyo Shinan Koho   1994–2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 2015/60013 A1  (Sharp Corp.),<br>30 April 2015 (30.04.2015),<br>paragraphs [0002] to [0049], [0053] to [0137];<br>fig. 1 to 10<br>& US 2016/0268450 A1<br>paragraphs [0002] to [0051], [0090] to [0174];<br>fig. 1 to 10 | 1–5<br>6–8 |
| Y | JP 2015-162498 A  (Japan Polyethylene Corp.),<br>07 September 2015 (07.09.2015),<br>paragraphs [0011], [0067]<br>(Family: none) | 6–8 |
| Y | JP 2014-135343 A  (Sharp Corp.),<br>24 July 2014 (24.07.2014),<br>paragraphs [0083] to [0086]<br>(Family: none) | 7–8 |

☒ Further documents are listed in the continuation of Box C.       ☐ See patent family annex.

| | |
|---|---|
| * Special categories of cited documents:<br>"A" document defining the general state of the art which is not considered    to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>    18 April 2017 (18.04.17) | Date of mailing of the international search report<br>    09 May 2017 (09.05.17) |
|---|---|
| Name and mailing address of the ISA/<br>   Japan Patent Office<br>   3-4-3,Kasumigaseki,Chiyoda-ku,<br>   Tokyo 100-8915,Japan | Authorized officer<br><br>Telephone No. |

Form PCT/ISA/210 (second sheet) (January 2015)

**EP 3 439 047 A1**

**INTERNATIONAL SEARCH REPORT**

International application No.

PCT/JP2017/007488

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 2014-239104 A (Shin-Etsu Chemical Co., Ltd.), 18 December 2014 (18.12.2014), paragraphs [0008] to [0009] (Family: none) | 1-8 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016064373 A
- JP 2016151024 A
- JP 2015095593 A
- JP 2014011270 A